(19) Europäisches Patentamt
European Patent Office
Office européen des brevets

(11) EP 4 576 979 A1

(12) EUROPEAN PATENT APPLICATION

(43) Date of publication:
25.06.2025 Bulletin 2025/26

(51) International Patent Classification (IPC):
H10B 51/20 (2023.01)   H10D 30/69 (2025.01)
H10D 64/01 (2025.01)   H10D 64/68 (2025.01)

(21) Application number: 24218036.2

(22) Date of filing: 06.12.2024

(52) Cooperative Patent Classification (CPC):
H10D 30/701; H10B 51/30; H10D 30/0415

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 19.12.2023 KR 20230186296

(71) Applicant: Samsung Electronics Co., Ltd.
Suwon-si, Gyeonggi-do 16677 (KR)

(72) Inventors:
• HYUN, Seungdam
16678 Suwon-si (KR)
• LEE, Hyunjae
16678 Suwon-si (KR)
• NAM, Seunggeol
16678 Suwon-si (KR)
• YOO, Sijung
16678 Suwon-si (KR)
• LEE, Minhyun
16678 Suwon-si (KR)
• CHOI, Seokhoon
16678 Suwon-si (KR)

(74) Representative: Elkington and Fife LLP
Prospect House
8 Pembroke Road
Sevenoaks, Kent TN13 1XR (GB)

(54) **VERTICAL NON-VOLATILE MEMORY DEVICE AND ELECTRONIC APPARATUS INCLUDING THE SAME**

(57) Provided are a vertical non-volatile memory device and an electronic apparatus including the same. The vertical non-volatile memory device includes a plurality of cell strings, each cell string of the plurality of cell strings includes a channel layer, a charge tunneling layer on the channel layer, a charge trap layer in the charge tunneling layer, a first charge blocking layer on the charge trap layer, a second charge blocking layer provided on the first charge blocking layer, and a gate electrode on the second charge blocking layer. The second charge blocking layer may include a first layer and a second layer, the first layer including a ferroelectric material or an anti-ferroelectric material, the second layer configured to facilitate crystallization of the first layer.

FIG. 7

**Description**

FIELD OF THE INVENTION

The inventive concepts relate to vertical non-volatile memory devices and electronic apparatuses including the vertical non-volatile memory devices.

BACKGROUND OF THE INVENTION

A non-volatile memory device includes a plurality of memory cells which retain data even when power thereto is blocked, and thus, are able to use the stored data when power is supplied again. A non-volatile memory device may be widely used in a cellular phone, a digital camera, a portable digital assistant (PDA), a mobile computer device, etc.
Recently, vertical NAND (VNAND) flash memory devices have been developed as high-density low-power is required, and as a degree of integration increases, interest in improving problems such as high program/erase voltages, small memory window, data retention, etc. is increasing.

SUMMARY OF THE INVENTION

Some example embodiments of the inventive concepts provide a vertical non-volatile memory device configured to increase the crystallinity of a charge blocking layer.
Some example embodiments of the inventive concepts provide an electronic apparatus including a vertical non-volatile memory device configured to increase the crystallinity of a charge blocking layer.
Additional aspects will be set forth in part in the description which follows and, in part, will be apparent from the description, or may be learned by practice of at least some of the example embodiments of the inventive concepts.
According to some example embodiments of the inventive concepts, a vertical non-volatile memory device may include a plurality of cell strings. Each cell string of the plurality of cell strings may include a channel layer, a charge tunneling layer on the channel layer, a charge trap layer on the charge tunneling layer, a first charge blocking layer on the charge trap layer, a second charge blocking layer on the first charge blocking layer, and a gate electrode on the second charge blocking layer. The second charge blocking layer may include a first layer including a ferroelectric material or an anti-ferroelectric material and a second layer configured to increase crystallization of the first layer.
Embodiments may provide a vertical NAND flash memory including high-k blocking oxide with seed layer/(anti) ferroelectric bilayer structure.
Proposed embodiments may be used to increase the degree of crystallinity of ferroelectric switching layers in ferroelectric VNAND memory to improve performance and lower process thermal budget,
Proposed embodiments consider doped HfO applied to a CTF VNAND product structure. As with conventional CTF, blocking oxide composed of SiO may be lengthily deposited from top to bottom, and high-k blocking oxide may be wrapped around the word line metal. Here, in embodiments, 2-3 nm thick doped HfO may be applied to the blocking oxide instead of conventional AlO. In such a case, 2-3 nm doped HfO may be difficult to crystallize, but in the case of a bilayer structure in which 1-2 nm doped HfO is deposited on top of a 1 nm ZrO seed layer, it may be easy to crystallize. The HfO crystallized on the ZrO seed exhibits strong FE/AFE characteristics and higher dielectric constant.
In summary, if doped HfO (FE/AFE layer) is applied instead of AlO, which is currently used as a BOX, the dielectric constant of the BOX may be greatly improved, which can reduce the program voltage, and therefore the size of the VNAND device can be reduced, which can increase the number of stacking layers.
A proposed embodiment may comprise a charge trap layer comprising a nano-crystal exhibiting antiferroelectric characteristic and a matrix that does not, in a VNAND flash memory cell. The nano-crystal may also exhibit ferroelectric characteristics. The nano-crystal may be formed by a method of spinodal decomposition or nucleation growth.
The second layer may be located between the first charge blocking layer and the first layer or is located between the first layer and the gate electrode.
The first layer may have a remnant polarization in a range of about 10 $\mu C/cm^2$ to about 30 $\mu C/cm^2$.
The first layer may have a permittivity in a range of about 30 to about 40.
The second layer may include one of ZrO, HfO, TaO, SiO, doped ZrO, doped HfO, doped TaO, doped SiO, Zr(O)N, Hf(O)N, Ta(O)N, Si(O)N, doped Zr(O)N, doped Hf(O)N, doped Ta(O)N, doped Si(O)N, or any combination thereof.
The second layer may have an amorphous crystal phase, a monoclinic crystal phase, a tetragonal crystal phase, an orthorhombic crystal phase, or a cubic crystal phase.
The first layer may include a fluorite-based material, a perovskite-based material, or a wurtzite-based material.
The fluorite-based material may include $HfO_2$ or $ZrO_2$.
The fluorite-based material may further include a dopant, and the dopant may include at least one of Al, Ga, Co, Ni, Mg, In, La, Y, Nd, Sm, Er, Sr, Ba, Gd, Ge, N, or Si.

The perovskite-based material may include a material having an ABOs composition, wherein A and B are metal elements.

The perovskite-based material may include at least one of PbZrOs, PbTiOs, BaTiOs, $SrTiO_3$ or CaTiOs.

The wurtzite-based material may include at least one of AIN, GaN, InN, doped AIN, doped GaN, or doped InN.

A crystallization temperature of the first layer may be about 600 °C to about 800 °C, and a crystallization temperature of the second layer may be about 200 °C to about 400 °C.

The first layer has a thickness in a range of about 1 nm to about 3 nm.

The second layer may have a thickness in a range of about 0.5 nm to about 1.5 nm.

The first layer and the second layer may be configured to surround three surfaces of the gate electrode.

The vertical non-volatile memory device may further include a diffusion barrier layer between the gate electrode and the second charge blocking layer.

The diffusion barrier layer may include at least one of titanium (Ti), zirconium (Zr), vanadium (V), aluminum (Al), lanthanum (La), niobium (Nb), or tantalum (Ta), or the diffusion barrier layer may include nitride including at least one of titanium (Ti), zirconium (Zr), vanadium (V), aluminum (Al), lanthanum (La), niobium (Nb), or tantalum (Ta).

According to some example embodiments of the inventive concepts, an electronic apparatus includes a memory, and a memory controller configured to control the memory to read data from the memory and/or write data to the memory, wherein the memory is a vertical non-volatile memory device including a plurality of cell strings, each cell string of the plurality of cell strings includes a channel layer, a charge tunneling layer on the channel layer, a charge trap layer on the charge tunneling layer, a first charge blocking layer on the charge trap layer, a second charge blocking layer on the first charge blocking layer, and a gate electrode on the second charge blocking layer. The second charge blocking layer may include a first layer including a ferroelectric material or an anti-ferroelectric material and a second layer configured to increase crystallization of the first layer.

The first layer may have a remnant polarization in a range of about 10 $\mu C/cm^2$ to about 30 $\mu C/cm^2$.

BRIEF DESCRIPTION OF THE DRAWINGS

The above and other aspects, features, and advantages of certain embodiments of the inventive concepts will be more apparent from the following description taken in conjunction with the accompanying drawings, in which:

FIG. 1 schematically illustrates a vertical non-volatile memory device according to some example embodiments;
FIG. 2 is a cross-sectional view taken along line A-A' of FIG. 1 according to some example embodiments;
FIGS. 3, 4, 5, 6, 7, and 8 are enlarged views of various examples of part A of FIG. 2 according to some example embodiments;
FIG. 9 is a circuit diagram illustrating a vertical non-volatile memory device according to some example embodiments;
FIG. 10 is a comparative example illustrating a change in a threshold voltage according to a program voltage when a dielectric layer is used as a charge blocking layer according to some example embodiments;
FIG. 11 illustrates a change in the threshold voltage according to the program voltage when an anti-ferroelectric layer is used as the charge blocking layer according to some example embodiments;
FIG. 12 illustrates a change in the threshold voltage according to the program voltage when a ferroelectric layer is used as the charge blocking layer according to some example embodiments;
FIG. 13 illustrates a change in an incremental step pulse programming (ISPP) slope according to the program voltage in case A where the anti-ferroelectric layer is used as the charge blocking layer and in case B where the dielectric layer is used as the charge blocking layer according to some example embodiments;
FIG. 14 illustrates a change in the ISPP slope according to the program voltage in case C where the ferroelectric layer is used as the charge blocking layer and in case D where the dielectric layer is used as the charge blocking layer according to some example embodiments;
FIG. 15 is a schematic block diagram illustrating a display driver IC (DDI) and a display apparatus including the DDI according to some example embodiments;
FIG. 16 is a block diagram illustrating an electronic apparatus according to some example embodiments;
FIG. 17 is a block diagram illustrating an electronic apparatus according to some example embodiments;
FIG. 18 is a conceptual diagram schematically illustrating a device architecture applicable to an electronic apparatus according to some example embodiments; and
FIG. 19 is a conceptual diagram schematically illustrating a device architecture applicable to an electronic apparatus according to some example embodiments.

DETAILED DESCRIPTION

Reference will now be made in detail to example embodiments, some of which are illustrated in the accompanying drawings, wherein like reference numerals refer to like elements throughout. In this regard, the present example embodiments may have different forms and should not be construed as being limited to the descriptions set forth herein. Accordingly, some example embodiments are described below, by referring to the figures, to explain aspects of the inventive concepts. As used herein, the term "and/or" includes any and all combinations of one or more of the associated listed items. Expressions such as "at least one of," when preceding a list of elements, modify the entire list of elements and do not modify the individual elements of the list.

Hereinafter, a vertical non-volatile memory device and an electronic apparatus including the vertical non-volatile memory device according to some embodiments are described in detail with reference to the attached drawings. In the drawings, like reference numerals in the drawings denote like elements, and sizes of components in the drawings may be exaggerated for clarity and convenience of explanation. While such terms as "first," "second," etc., may be used to describe various components, such components must not be limited to the above terms. The above terms are used only to distinguish one component from another.

An expression used in the singular encompasses the expression of the plural, unless it has a clearly different meaning in the context. When a portion "includes" a component, another component may be further included, rather than excluding the existence of the other component, unless otherwise described. Sizes or thicknesses of components in the drawings may be arbitrarily exaggerated for convenience of explanation. Further, when a certain material layer is described as being arranged on a substrate or another layer, the material layer may be in contact with the other layer, or there may be a third layer between the material layer and the other layer. In some example embodiments herein, materials constituting each layer are provided merely as an example, and other materials may also be used.

Hereinafter, some example embodiments of the inventive concepts will be described in detail with reference to the accompanying drawings. The same reference numerals are used for the same components in the drawings, and redundant descriptions thereof are omitted.

Throughout the specification, when a part is "connected" to another part, it includes not only a case where the part is "directly connected" but also a case where the part is "indirectly connected" with another part in between. In addition, unless explicitly described to the contrary, the word "comprise" and variations such as "comprises" or "comprising" will be understood to imply the inclusion of stated elements but not the exclusion of any other elements.

It will be understood that when an element such as a layer, film, region, area, or substrate is referred to as being "on" another element, it can be directly on the other element or intervening elements may also be present. In contrast, when an element is referred to as being "directly on" another element, there are no intervening elements present. Further, in the specification, an element that is "on" another element may be above, beneath, or horizontally next to (e.g., horizontally adjacent to) the other element and is not necessarily above an upper side of the other element based on a gravitational direction.

The use of the term "the" and similar demonstratives may correspond to both the singular and the plural. Operations constituting methods may be performed in any suitable order unless otherwise indicated herein or otherwise clearly contradicted by context and are not necessarily limited to the stated order.

The use of all illustrations or illustrative terms in some example embodiments is simply to describe the technical ideas in detail, and the scope of the present inventive concepts is not limited by the illustrations or illustrative terms unless they are limited by claims.

It will be understood that elements and/or properties thereof (e.g., structures, surfaces, directions, or the like), which may be referred to as being "perpendicular," "parallel," "coplanar," or the like with regard to other elements and/or properties thereof (e.g., structures, surfaces, directions, or the like) may be "perpendicular," "parallel," "coplanar," or the like or may be "substantially perpendicular," "substantially parallel," "substantially coplanar," respectively, with regard to the other elements and/or properties thereof.

Elements and/or properties thereof (e.g., structures, surfaces, directions, or the like) that are "substantially perpendicular", "substantially parallel", or "substantially coplanar" with regard to other elements and/or properties thereof will be understood to be "perpendicular", "parallel", or "coplanar", respectively, with regard to the other elements and/or properties thereof within manufacturing tolerances and/or material tolerances and/or have a deviation in magnitude and/or angle from "perpendicular", "parallel", or "coplanar", respectively, with regard to the other elements and/or properties thereof that is equal to or less than 10% (e.g., a. tolerance of $\pm 10\%$).

It will be understood that elements and/or properties thereof may be recited herein as being "the same" or "equal" as other elements, and it will be further understood that elements and/or properties thereof recited herein as being "identical" to, "the same" as, or "equal" to other elements may be "identical" to, "the same" as, or "equal" to or "substantially identical" to, "substantially the same" as or "substantially equal" to the other elements and/or properties thereof. Elements and/or properties thereof that are "substantially identical" to, "substantially the same" as or "substantially equal" to other elements and/or properties thereof will be understood to include elements and/or properties thereof that are identical to, the same as, or equal to the other elements and/or properties thereof within manufacturing tolerances and/or material tolerances. Elements and/or properties thereof that are identical or substantially identical to and/or the same or substantially the same as other elements and/or properties thereof may be structurally the same or substantially the same, functionally the same or substantially the same, and/or compositionally the same or substantially the same. While the term "same," "equal" or "identical" may be used in description of some example embodiments, it should be understood that some imprecisions may exist. Thus, when one element is referred to as being the same as another element, it should be understood that an element or a value is the same as another element within a desired manufacturing or operational tolerance range (e.g., ±10%).

It will be understood that elements and/or properties thereof described herein as being "substantially" the same and/or identical encompasses elements and/or properties thereof that have a relative difference in magnitude that is equal to or less than 10%. Further, regardless of whether elements and/or properties thereof are modified as "substantially," it will be understood that these elements and/or properties thereof should be construed as including a manufacturing or operational tolerance (e.g., ±10%) around the stated elements and/or properties thereof.

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes. When ranges are specified, the range includes all values therebetween such as increments of 0.1%.

As described herein, when an operation is described to be performed, or an effect such as a structure is described to be established "by" or "through" performing additional operations, it will be understood that the operation may be performed and/or the effect/structure may be established "based on" the additional operations, which may include performing said additional operations alone or in combination with other further additional operations.

As described herein, an element that is described to be "spaced apart" from another element, in general and/or in a particular direction (e.g., vertically spaced apart, laterally spaced apart, etc.) and/or described to be "separated from" the other element, may be understood to be isolated from direct contact with the other element, in general and/or in the particular direction (e.g., isolated from direct contact with the other element in a vertical direction, isolated from direct contact with the other element in a lateral or horizontal direction, etc.). Similarly, elements that are described to be "spaced apart" from each other, in general and/or in a particular direction (e.g., vertically spaced apart, laterally spaced apart, etc.) and/or are described to be "separated" from each other, may be understood to be isolated from direct contact with each other, in general and/or in the particular direction (e.g., isolated from direct contact with each other in a vertical direction, isolated from direct contact with each other in a lateral or horizontal direction, etc.). Similarly, a structure described herein to be between two other structures to separate the two other structures from each other may be understood to be configured to isolate the two other structures from direct contact with each other.

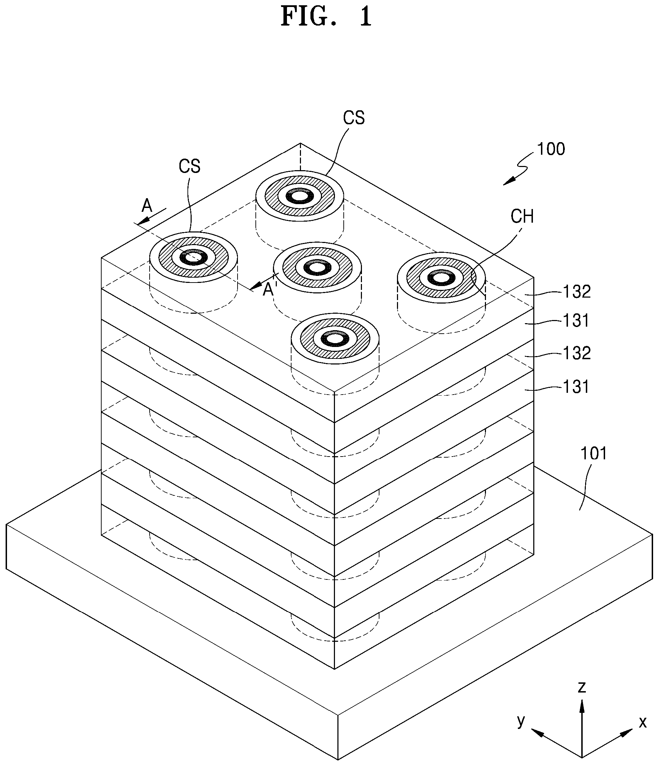

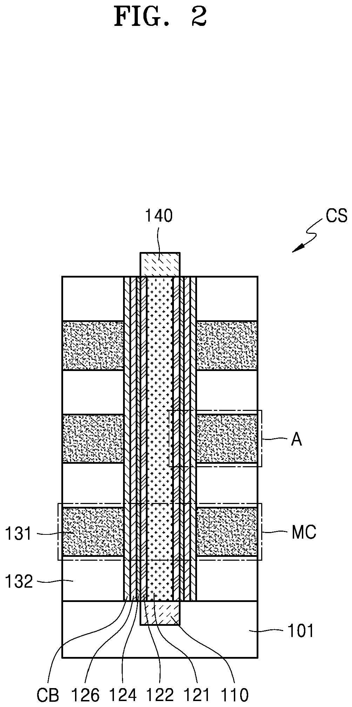

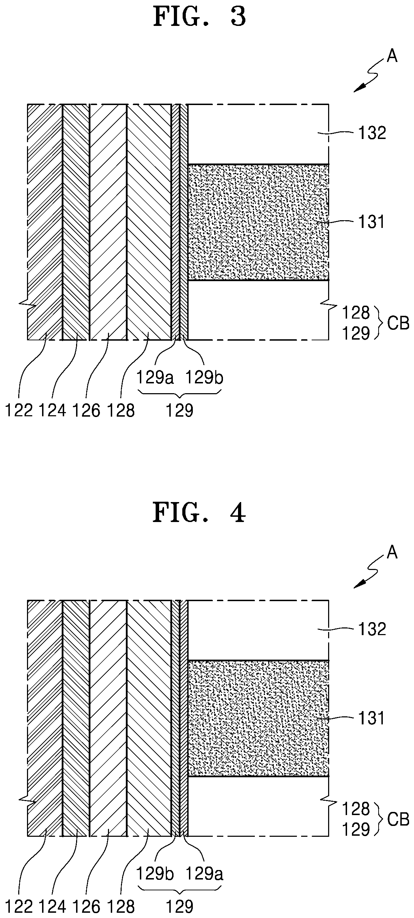

FIG. 1 schematically illustrates a vertical non-volatile memory device 100 according to some example embodiments. FIG. 2 is a cross-sectional view taken along line A-A' of FIG. 1 according to some example embodiments. FIGS. 3, 4, 5, 6, 7, and 8 are enlarged views of various examples of part A of FIG. 2 according to some example embodiments.

Referring to FIG. 1, a vertical non-volatile memory device 100 includes a plurality of cell strings CS disposed on a substrate 101. Here, each cell string CS may be provided to extend in a direction (z-axis direction in FIG. 1) perpendicular to the substrate 101. The plurality of cell strings CS may be disposed on the substrate 101 in various forms. Gate electrodes 131 and separation layers 132 may be alternately stacked on the substrate 101. Channel holes CH may be provided in a stack structure of the gate electrodes 131 and the separation layers 132 to penetrate the substrate 101 in the direction (z-axis direction) perpendicular to the substrate 101. The channel hole CH may be formed to have, for example, a circular cross-section. However, a cross-sectional shape of the channel hole CH is not limited thereto.

A region of the cell string CS except for the gate electrode 131 and the separation layer 132 may have a stack structure of a plurality of cylindrical shells in the channel hole CH. However, the structure of the cell string CS is not limited thereto, and may have different shapes and structures.

The substrate 101 may include a single crystal silicon substrate, a compound semiconductor substrate, or a silicon-on-insulator (SOI) substrate, but is not limited thereto. In addition, the substrate 101 may further include, for example, an impurity region caused by doping, an electronic apparatus such as a transistor, or a peripheral circuit that selects and controls memory cells that store data.

Referring to FIG. 2, the cell string CS may include a plurality of memory cells MC stacked in the direction (z-axis direction) perpendicular to the substrate 101. The memory cell MC may be a basic unit cell for writing and erasing data.

The cell string CS may include a pillar 121 extending in a direction perpendicular to the substrate 101, a channel layer 122 provided on the pillar 121, a charge tunneling layer 124 provided on the channel layer 122, a charge trap layer 126 provided on the charge tunneling layer 124, a charge blocking layer CB provided on the charge trap layer 126, and a gate electrode 131 provided on the charge blocking layer CB.

The pillar 121 may include, for example, silicon oxide or air, but is not limited thereto. Each of the channel layer 122, the charge tunneling layer 124, and the charge trap layer 126 may be provided to vertically extend on and/or in the substrate 101 and shared by the plurality of memory cells MC.

The channel layer 122 may include a semiconductor material. The channel layer 122 may include, for example, Si, Ge, SiGe, group III-V semiconductor, etc. The channel layer 122 may include, for example, an oxide semiconductor, a nitride semiconductor, a nitric oxide semiconductor, a two-dimensional (2D) semiconductor material, a quantum dot (QD), or an organic semiconductor. Here, the oxide semiconductor may include, for example, InGaZnO, etc. The 2D semiconductor material may include, for example, transition metal dichalcogenide (TMD) or graphene, and the QD may include a colloidal QD, a nanocrystal structure, etc. The 2D semiconductor material refers to a semiconductor material having a 2D crystal structure, and may have a monolayer or multilayer structure. The 2D semiconductor material has excellent electrical properties and does not significantly change and maintains high mobility even when a thickness thereof is reduced to a nano scale. Each of layers constituting the 2D semiconductor material may have an atomic level thickness. The channel layer 122 may include 1 to 10 2D semiconductor material layers.

The 2D semiconductor material may include, for example, at least one of graphene, black phosphorous, or transition metal dichalcogenide (TMD). The graphene is a material in which carbon atoms are 2D combined to have a hexagonal honeycomb structure, has higher electrical mobility and excellent thermal characteristics than silicon (Si), is chemically stable, and has a large surface area. In addition, the black phosphorus is a material in which black phosphorous atoms are 2D combined.

The TMD may be represented by, for example, $MX_2$, where M represents a transition metal and X represents a chalcogen element. For example, M may include Mo, W, Nb, V, Ta, Ti, Zr, Hf, Tc, or Re, and X may include S, Se, or Te. Therefore, for example, the TMD may include $MoS_2$, $MoSe_2$, $MoTe_2$, $WS_2$, $WSe_2$, $WTe_2$, $ZrS_2$, $ZrSe_2$, $HfS_2$, $HfSe_2$, $NbSe_2$, or $ReSe_2$.

In some example embodiments, the 2D semiconductor material may include Cu, which is a transition metal, and CuS, which is a compound of S, which is a chalcogen element. Meanwhile, the 2D semiconductor material may be a chalcogenide material including a non-transition metal. The non-transition metal may include, for example, Ga, In, Sn, Ge, Pb, etc. In this case, the 2D semiconductor material may include compounds of the non-transition metal such as Ga, In, Sn, Ge, Pb, etc. and the chalcogen element such as S, Se, and Te. For example, the 2D semiconductor material may include $SnSe_2$, GaS, GaSe, GaTe, GeSe, $In_2Ses$, $InSnS_2$, etc. However, the materials mentioned above are only examples, and other materials may be used as the 2D semiconductor material.

The channel layer 122 may further include a dopant. Here, the dopant may include a p-type dopant or an n-type dopant. The p-type dopant may include, for example, a Group III element such as B, Al, Ga, In, etc., and the n-type dopant may include, for example, a Group V element such as P, As, Sb, etc.

The charge tunneling layer 124 is a layer in which charge tunneling is performed, and may include, for example, silicon oxide or metal oxide, but is not limited thereto.

The gate electrodes 131 are stacked to be spaced apart from each other in the direction perpendicular to the substrate 101 (z-axis direction), and the separation layer 132 may be provided between the gate electrode 131 and the gate electrode 131 (e.g., between adjacent gate electrodes 131 in the z-axis direction). The separation layer 132 may include an insulating material, and may separate the gate electrodes 131 to be independently driven in units of memory cells MC. A source electrode and a drain electrode are not illustrated in FIG. 1, but a source electrode 110 and a drain electrode 140 are illustrated in FIG. 2. The source electrode 110 may be provided in a lower portion of the channel layer 122, and the drain electrode 140 may be provided in an upper portion of the channel layer 122. The drain electrode 140 may be connected to a bit line (not shown).

FIG. 2 shows that the source electrodes 110 are respectively connected to the cell strings CS (e.g., separate source electrodes 110 may be connected to separate, respective cell strings CS), but the source electrodes 110 may be connected in common to each cell string CS. FIG. 2 shows that the charge blocking layer CB is a monolayer, but this is simplified for convenience, and a detailed configuration thereof will be described below.

FIG. 3 is an enlarged view of part A of FIG. 2 according to some example embodiments.

The channel layer 122 may be provided to surround (e.g., surround in one or more directions and/or a plane parallel to the substrate 101, for example the x-axis and/or y-axis directions and/or in a plane extending in the x-axis and y-axis directions) a side surface (e.g., outer side surface) of the pillar 121, the charge tunneling layer 124 may be provided to surround (e.g., surround in one or more directions and/or a plane parallel to the substrate 101, for example the x-axis and/or y-axis directions and/or in a plane extending in the x-axis and y-axis directions) a side surface (e.g., outer side surface) of the channel layer 122, the charge trap layer 126 may be provided to surround (e.g., surround in one or more directions and/or a plane parallel to the substrate 101, for example the x-axis and/or y-axis directions and/or in a plane extending in the x-axis and y-axis directions) a side surface (e.g., outer side surface) of the charge tunneling layer 124, and the charge blocking layer CB may be provided to surround (e.g., surround in one or more directions and/or a plane parallel to the substrate 101, for example the x-axis and/or y-axis directions and/or in a plane extending in the x-axis and y-axis directions) a side surface (e.g., outer side surface) of the charge trap layer 126.

In addition, the gate electrodes 131 and the separation layers 132 may be alternately arranged along the side surface of the charge blocking layer CB (e.g., alternately arranged in the z-axis direction). Each channel corresponding to the gate electrode 131 may be formed in the channel layer 122 between the source electrode 110 and the drain electrode 140. When a certain voltage is applied to the gate electrode 131 in each memory cell MC, charges flowing between the source electrode 110 and the drain electrode 140 in the channel layer 122 corresponding to the gate electrode 131 may pass through the charge tunneling layer 124 and be captured in the charge trap layer 126, and thus, information may be stored.

The gate electrode 131 may control the corresponding channel layer 122, and a word line may be electrically connected to the gate electrode 131. The gate electrode 131 may include a metal material having excellent electrical conductivity, conductive material, oxide, metal nitride, silicon doped with impurities, or a 2D conductive material. The metal material may include, for example, Au, Ti, TiN, TaN, W, Mo, WN, Pt, Nb, NbN, or Ni, or any combination thereof. The conductive oxide may include, for example, indium tin oxide (ITO), indium zinc oxide (IZO), indium zinc oxide (IZO), etc. However, this is only an example, and the gate electrode 131 may include various other materials. The separation layer 132 may serve as a spacer layer for insulation between the gate electrodes 131. The separation layer 132 may include, for example, silicon oxide, silicon nitride, etc., but is not limited thereto.

The charge blocking layer CB may function as a barrier preventing charge movement between the charge trap layer 126 and the gate electrode 131. One surface of the charge blocking layer CB may be in contact with the charge trap layer 126, and the other surface of the charge blocking layer CB may be in contact with the gate electrode 131.

The charge trap layer 126 may store introduced charges. Charges (e.g., electrons) present in the channel layer 122 may be introduced into the charge trap layer 126 by a tunneling effect, etc. The charges introduced into the charge trap layer 126 may be fixed to the charge trap layer 126.

A reliability factor required by vertical non-volatile memory devices is the retention of data, that is, the characteristic of storing charges in the charge trap layer 126 for a long time. When distances between the memory cells MC are reduced to increase the memory density in the vertical non-volatile memory device 100, trapped charges may move between the memory cells MC, and accordingly, charge retention characteristics may deteriorate.

Charges may move from the charge trap layer 126 to the charge tunneling layer 124 through trap-assisted tunneling or thermal emission in a direction perpendicular to the charge trap layer 126. A degree of movement of charges may be determined by a conduction band offset (CBO) at an interface between the charge trap layer 126 and the charge tunneling layer 124.

In the direction parallel to the charge trap layer 126, the movement of charges may occur by a lateral migration in accordance with a gradient of a charge concentration. The movement of charges in the direction parallel to the charge trap layer 126 may be dominated by Poole-Frenkel tunneling. The current density by Poole-Frenkel tunneling may be expressed by the following Poole-Frenkel Conduction Equation (Equation 1).

$$ J = q\mu N_c E \, exp\left(\frac{-q\left(E_T - \sqrt{qE/\pi\varepsilon}\right)}{kT}\right) \qquad \cdots \quad (equation\ 1) $$

(J : current Density, q : electronic charge, $\mu$ : carrier mobility, $N_c$: density of states in conduction band, E : electric field, $E_T$ : trap energy, $\varepsilon$ : permittivity, k : Boltzmann constant, T : temperature)

The movement of charges in the direction parallel to the charge trap layer 126 by Poole-Frenkel tunneling may be determined by trap energy $E_T$ and trap density $N_T$ in the charge trap layer 126. The trap energy $E_T$ refers to a voltage barrier that electrons need to cross in order to move from one atom to another in a material. In other words, the trap energy $E_T$ refers to a depth of a trap state with respect to a conduction band minimum (CBM) of a material. The trap density $N_T$ refers to the number of trapped charges per unit volume. The trap density $N_T$ may be calculated using a charge pumping method. The charge retention characteristic in the direction parallel to the charge trap layer 126 may be improved by high trap energy $E_T$ and high trap density $N_T$.

The charge trap layer 126 may include at least one of, for example, silicon nitride (SiN), gallium nitride (GaN), gallium oxide (GaO), hafnium oxide (HfO), scandium oxide (ScO), strontium oxide (SrO), zirconium oxide (ZrO), yttrium oxide (YO), tantalum oxide (TaO), barium oxide (BaO), or zinc sulfide (ZnS).

In some example embodiments, the charge trap layer 126 may include a matrix and nanocrystals provided (e.g., dispersed in, for example at a constant or substantially constant concentration) in the matrix. The matrix may include amorphous metal oxynitride, such that the charge trap layer 126 may include an amorphous metal oxynitride in which nanocrystals having semiconductor characteristics are dispersed (e.g., such that the charge trap layer 126 may have a constant or substantially constant concentration and/or density of the nanocrystals throughout the amorphous metal oxynitride and/or the charge trap layer 126). The matrix may include metal oxynitride having a higher permittivity than that of silicon nitride. For example, the matrix may include at least one of AlON, ZrON, LaON, AlSiON, HfAlON, LaSiON, AlZrON, LaAlON, HfAlON, or ZrSiON. However, the matrix is not limited thereto. For example, the nanocrystals may include at least one of AlN, GaN, GeN, SiN, CN, InN, YN, ScN, orZrN. However, the nanocrystals are not limited thereto.

The charge trap layer 126 may include the amorphous metal oxynitride in which the nanocrystals having semiconductor characteristics are dispersed, which may increase the trap energy $E_T$ and the trap density $N_T$, and suppress the movement of trapped charges between the memory cells MC, thereby improving the charge retention characteristics. Accordingly, the memory operation characteristics of the vertical non-volatile memory device 100 may be improved by decreasing a threshold voltage as a result of the charge trap layer 126 including an amorphous metal oxynitride in which nanocrystals having semiconductor characteristics are dispersed.

The charge blocking layer CB serves to prevent charges from leaking to the separation layer 132 and the gate electrode 131 beyond the charge trap layer 126, or to reduce or minimize such leakage. The charge blocking layer CB may include, for example, a first charge blocking layer 128 provided on the charge trap layer 126 and a second charge blocking layer 129 provided on the first charge blocking layer 128. The first charge blocking layer 128 may be provided to be in direct contact with the charge trap layer 126 (e.g., an outer side surface thereof). However, the example embodiments are not limited thereto, and another layer may be intervened (e.g., interposed) between the charge trap layer 126 and the first charge blocking layer 128. The first charge blocking layer 128 may include silicon oxide, metal oxide, or metal nitride, but is not limited thereto. The first charge blocking layer 128 may include at least one of aluminum oxide (AlO), magnesium oxide (MgO), aluminum nitride (AlN), or gallium nitride (GaN). The first charge blocking layer 128 may include, for example, $SiO_2$ or $Al_2O_3$.

The second charge blocking layer 129 may include a first layer 129a including a ferroelectric material or an anti-ferroelectric material and a second layer 129b configured to help (e.g., increase, facilitate, trigger, induce, initiate, enhance, promote, etc.) crystallization of the first layer 129a.

The ferroelectric material has ferroelectricity that may maintain spontaneous polarization by aligning internal electrical dipole moments even when an electric field is not applied from outside. The ferroelectric material exhibits spontaneous polarization with permanent dipoles arranged in parallel in the same direction. The ferroelectric material may have remnant polarization due to dipoles even while there is no external electric field. In addition, directions of polarization may be switched in units of domains by the external electric field. The threshold voltage of the vertical non-volatile memory device 100 may change according to the polarization direction of the ferroelectric material, for example, from the gate electrode 131 to the channel layer 122 or vice versa.

The anti-ferroelectric material may include an array of electrical dipoles, but the remnant polarization may be zero or close to zero. The overall spontaneous polarization and remnant polarization may be zero or close to zero as directions of adjacent dipoles are reversed in the absence of an electric field and thus polarization is cancelled. However, when the external electric field is applied, polarization characteristics and switching characteristics may be exhibited.

The ferroelectric material may include a hafnium oxide material or an aluminum nitride material. The ferroelectric material may have a structure in which a dopant is inserted into a hafnium oxide-based material or a structure in which a dopant is inserted into an aluminum nitride-based material. When the ferroelectric material is the hafnium oxide-based material, the dopant may be Zr, La, Al, Si, or Y. When the ferroelectric material is the aluminum nitride-based material, the dopant may be B or Sc.

In some example embodiments, the ferroelectric material may include, for example, a ferroelectric material having at least one of a fluorite structure (e.g., a fluorite-based material), a perovskite structure (e.g., a perovskite-based material), or a wurtzite structure (e.g., a wurtzite-based material).

The ferroelectric material of the fluorite structure may include, for example, $HfO_2$ or $ZrO_2$. Here, $HfO_2$ or $ZrO_z$ may have a tetragonal system crystal structure or an orthorhombic system crystal structure. The tetragonal system crystal structure may have anti-ferroelectricity, and the orthorhombic system crystal structure may have ferroelectricity. $HfO_2$ which is undoped may have a stable tetragonal system crystal structure, but may have the orthorhombic system crystal structure depending on a grain size. $ZrO_2$ which is undoped may have a stable tetragonal system crystal structure. The undoped $HfO_2$ or $ZrO_z$ may include, for example, nanocrystals having the grain size of about 1 nm to about 3 nm, but is not limited thereto.

A fluorite-based material may include, for example, $HfO_2$ or $ZrO_2$ including a dopant. Here, the dopant may include at least one of, for example, Al, Ga, Co, Ni, Mg, In, La, Y, Nd, Sm, Er, Sr, Ba, Gd, Ge, N, or Si. However, this is merely an example. $HfO_2$ or $ZrO_2$ including the dopant may have the tetragonal system crystal structure having anti-ferroelectricity or the orthorhombic system crystal structure having ferroelectricity according to a crystal grain size and a doping concentration. The smaller the grain size and the higher the doping concentration, the more stable the tetragonal system crystal structure, and the larger the grain size and the lower the doping concentration, the more stable the orthorhombic system crystal structure.

$HfO_2$ or $ZrO_2$ doped with the dopant may include nanocrystals having a larger grain size than that of the above-described undoped $HfO_2$ or $ZrO_2$. For example, $HfO_2$ or $ZrO_2$ doped with the dopant may have the grain size of about 4 nm to about 7 nm, or about 4 nm to about 5 nm, but is not limited thereto.

The concentration of the dopant may be changed in various ways according to a type of dopant. For example, when the dopant is Si, the doping concentration may be about 1 at% to about 5 at%. However, the doping concentration is not limited thereto.

The ferroelectric material having the perovskite structure may include a material having an ABOs composition (A and B are metal elements). A perovskite-based material may include at least one of, for example, $PbZrO_3$, $PbTiO_3$, $BaTiO_3$, $SrTiO_3$ or $CaTiO_3$. However, the perovskite-based material is not limited thereto. The perovskite-based material may have the tetragonal system crystal structure having anti-ferroelectricity or the orthorhombic system crystal structure having ferroelectricity according to a composition ratio of constituent elements.

A wurtzite-based material may include undoped AlN, GaN, or InN, or may include AlN, GaN, or InN each including a dopant. A wurtzite-based material may include at least one of AlN, GaN, InN, doped AlN, doped GaN, or doped InN. The dopant may include at least one of boron (B) or scandium (Sc).

For example, the first layer 129a may include hafnium zirconium oxide (HfZrO), and Zr/(Hf+Zr) may have a range of about 20 at% to about 80 at%.

In some example embodiments, the first layer 129a and the second layer 129b may further increase ferroelectric/anti-ferroelectricity through interaction, and increase the remnant polarization. For example, the first layer 129a may have a remnant polarization in a range of about 10 $\mu C/cm^2$ to about 30 $\mu C/cm^2$. In addition, a permittivity of the first layer 129a may be increased. For example, the first layer 129a may have the permittivity (which may be a relative permittivity which is a ratio of the absolute permittivity of the first layer 129a and vacuum permittivity) in a range of about 30 to about 40.

The second layer 129b may be a seed layer configured to enhance (e.g., facilitate, trigger, induce, initiate, promote, etc.) crystallization of the first layer 129a. The second layer 129b may be disposed between (e.g., directly or indirectly between) the first layer 129a and the gate electrode 131. The first layer 129a and the second layer 129b may be provided along a side surface of the first charge blocking layer 128 throughout the cell string CS. However, an installation section of the first layer 129a and the second layer 129b is not limited thereto and may be changed in various ways.

The second layer 129b may include a material having a crystal structure similar to that of the first layer 129a. The second layer 129b may have a thickness in a range of about 0.5 nm to about 1.5 nm. The second layer 129b may include one of ZrO, HfO, TaO, SiO, doped ZrO, doped HfO, doped TaO, doped SiO, Zr(O)N, Hf(O)N, Ta(O)N, Si(O)N, doped Zr(O)N, doped Hf(O)N, doped Ta(O)N, doped Si(O)N, or any combination thereof. The dopant may include at least one of, for example, Al, Ga, Co, Ni, Mg, In, La, Y, Nd, Sm, Er, Sr, Ba, Gd, Ge, N, B, Sc, or Si. The second layer 129b may have an amorphous, monoclinic, tetragonal, orthorhombic, or cubic crystal phase (e.g., an amorphous crystal phase, a monoclinic crystal phase, a tetragonal crystal phase, an orthorhombic crystal phase, or a cubic crystal phase).

When crystallizing the first layer 129a having a very small thickness (e.g., about 2 nm to about 3 nm, although example embodiments are not limited thereto), the crystallization of the first layer 129a may be enhanced by the second layer 129b. A crystallization temperature of the first layer 129a may be reduced (e.g., based on the second layer 129b being present and contacting the first layer 129a) compared to when the second layer 129b is not present, and thus, damage to the first layer 129a may be suppressed during the crystallization of the first layer 129a having the very small thickness. The crystallization temperature of the first layer 129a may be about 600 °C to 800 °C, and the crystallization temperature of the second layer 129b may be about 200°C to about 400 °C. In some example embodiments, the crystallization temperature of the first layer 129a may be about 600 °C to about 750 °C, and the crystallization temperature of the second layer 129b may be about 200 °C to about 350 °C. In some example embodiments, when (e.g., based on) the second layer 129b is in contact with the gate electrode 131, the first layer 129a (which may be in contact with an opposite side surface of the second layer 129b) is crystallized from the gate electrode 131 through the second layer 129b, thereby promoting the crystallization of the first layer 129a.

FIG. 4 illustrates an example in which positions of the first layer 129a and the second layer 129b are changed as compared with FIG. 3 according to some example embodiments. The first layer 129a may be provided to contact the gate electrode 131, and the second layer 129b may be provided between (e.g., directly or indirectly between) the first charge blocking layer 128 and the first layer 129a. In some example embodiments, the second layer 129b may start to crystallize, and the first layer 129a may be sequentially crystallized. Even when the first layer 129a has a thin thickness due to the second layer 129b, the first layer 129a may be satisfactorily crystallized, based on the presence of the second layer 129b promoting the crystallization of the first layer 129a.

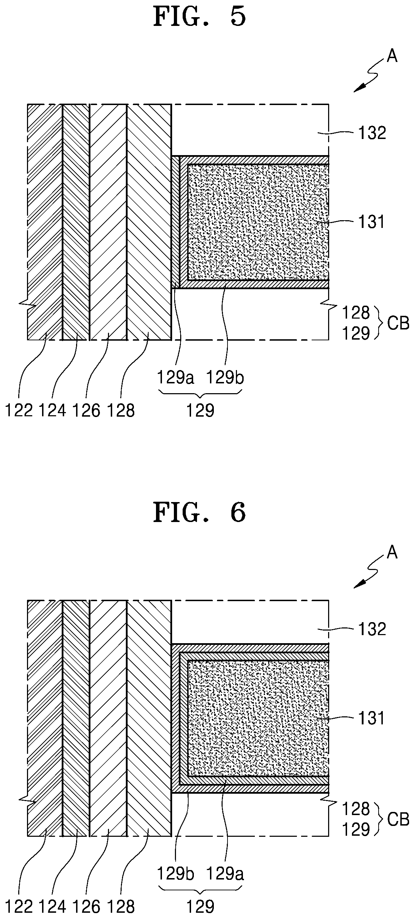

FIG. 5 illustrates an example of changing structures of the first layer 129a and the second layer 129b according to some example embodiments. The second layer 129b may be provided to surround some of surfaces of the gate electrode 131. For example, the second layer 129b may be provided to surround three surfaces of the gate electrode 131. As described above, the second layer 129b may be independently provided for each memory cell MC. The first layer 129a may be provided between the first charge blocking layer 128 and the second layer 129b, and the first layer 129a may also be provided independently for each memory cell MC. However, the first layer 129a may be commonly provided in the cell string CS. That is, the first layer 129a may be provided over the entire cell string CS along a side surface of the first charge blocking layer 128. Meanwhile, in some example embodiments, the positions of the first layer 129a and the second layer 129b may be switched.

FIG. 6 illustrates another example of the first layer 129a and the second layer 129b according to some example embodiments.

The first layer 129a may be provided to surround some of surfaces of the gate electrode 131. For example, the first layer 129a may be provided to surround three surfaces of the gate electrode 131. As described above, the first layer 129a may be independently provided for each memory cell MC. The second layer 129b may be provided along the surface of the first layer 129a. As described above, the second layer 129b may be provided to surround three surfaces of the first layer 129a, and may be provided independently for each memory cell MC. In FIG. 6, the first layer 129a is provided to contact the gate electrode 131, but the positions of the first layer 129a and the second layer 129b may be switched so that the first layer 129a is provided to contact the gate electrode 131.

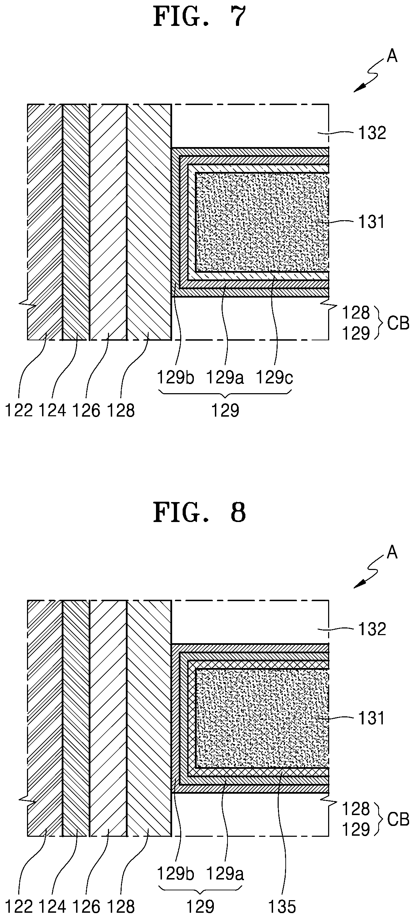

FIG. 7 illustrates an example in which a structure of the second charge blocking layer 129 is changed according to some example embodiments.

The second charge blocking layer 129 may include the first layer 129a, the second layer 129b, and a third layer 129c. The second layer 129b may be provided on one side of the first layer 129a, and the third layer 129c may be provided on the other (e.g., opposite) side of the first layer 129a. The second layer 129b and the third layer 129c may be provided on both (e.g., opposite) sides of the first layer 129a to serve as a seed layer that enhances (e.g., increases) the crystallization of the first layer 129a. The third layer 129c may have a thickness in a range of about 0.5 nm to about 1.5 nm. The third layer 129c may include one of ZrO, HfO, TaO, SiO, doped ZrO, doped HfO, doped TaO, doped SiO, Zr(O)N, Hf(O)N, Ta(O)N, Si(O)N, doped Zr(O)N, doped Hf(O)N, doped Ta(O)N, doped Si(O)N, or any combination thereof. The dopant may include at least one of, for example, Al, Ga, Co, Ni, Mg, In, La, Y, Nd, Sm, Er, Sr, Ba, Gd, Ge, N, B, Sc, or Si. The third layer 129c may have an amorphous, monoclinic, tetragonal, orthorhombic, or cubic crystal phase (e.g., an amorphous crystal phase, a monoclinic crystal phase, a tetragonal crystal phase, an orthorhombic crystal phase, or a cubic crystal phase). The second layer 129b and the third layer 129c may include the same material or different materials.

The third layer 129c may be provided to surround some of surfaces of the gate electrode 131, the first layer 129a may be provided to surround the third layer 129c, and the second layer 129b may be provided to surround the first layer 129a. Here, the first layer 129a, the second layer 129b, and the third layer 129c may be independently provided for each memory cell MC. However, the structures of the first layer 129a, the second layer 129b, and the third layer 129c are not limited thereto. The first layer 129a, the second layer 129b, and the third layer 129c may be commonly provided in the entire cell string CS, the second layer 129b may be commonly provided in the entire cell string CS, and the first layer 129a and the third layer 129c may be independently provided in each memory cell MC.

FIG. 8 illustrates an example in which the second charge blocking layer 129 further includes a diffusion barrier layer 135 according to some example embodiments. The diffusion barrier layer 135 may prevent reaction and diffusion between the gate electrode 131 and the separation layer 132 or between the interfaces between the gate electrode 131 and the charge trap layer 126, or reduce or minimize such reaction and diffusion. The diffusion barrier layer 135 may include a material of the separation layer 132, for example, a material having an oxidation-reduction potential greater than that of $SiO_2$. The diffusion barrier layer 135 may include at least one of titanium (Ti), zirconium (Zr), vanadium (V), aluminum (Al), lanthanum (La), niobium (Nb), or tantalum (Ta) or may include nitride including at least one of these. The diffusion barrier layer 135 may include, for example, TiN or NbN.

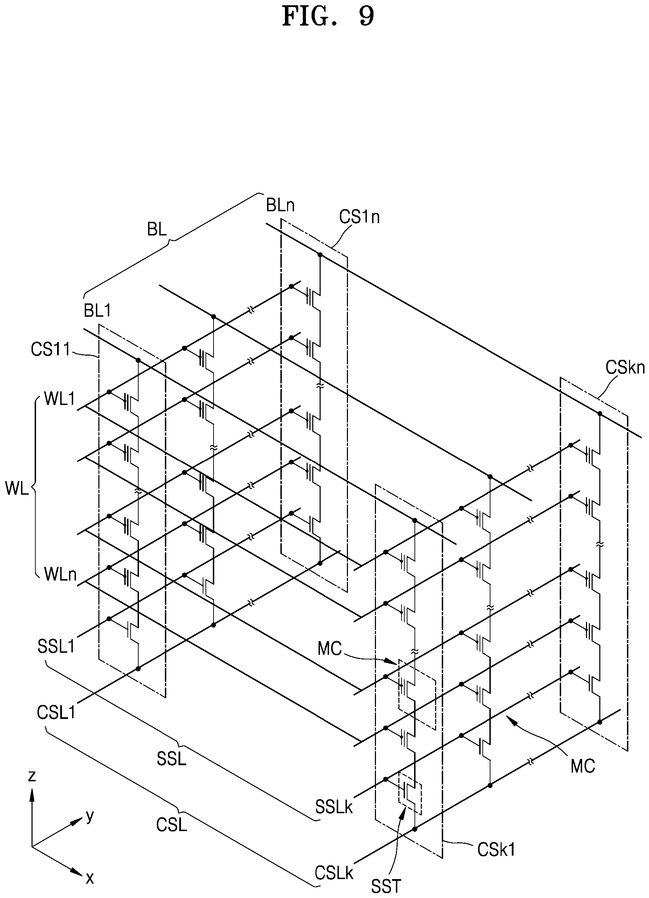

FIG. 9 is a circuit diagram illustrating a vertical non-volatile memory device according to some example embodiments. k*n cell strings CS may be provided and arranged in a matrix form, and may be named as CSij ($1 \leq i \leq k$, $1 \leq j \leq n$) according to positions of each row and column, where k and n may each independently be any positive integer. Each cell string CSij is connected to a bit line BL, a string selection line SSL, a word line WL, and the common source line CSL.

Each cell string CSij includes memory cells MC and a string selection transistor SST. The memory cells MC and the string selection transistor SST of each cell string CSij may be stacked in a height direction.

Rows of the plurality of cell strings CS are respectively connected to different string selection lines SSL1 to SSLk. For example, the string selection transistors SST of cell strings CS11 to CS1n are commonly connected to the string selection line SSL1. The string selection transistors SST of cell strings CSk1 to CSkn are commonly connected to the string selection line SSLk.

Columns of the plurality of cell strings CS are respectively connected to different bit lines BL1 to BLn. For example, the memory cells MC and the string selection transistors SST of the cell strings CS11 to CSk1 may be commonly connected to the bit line BL1, and the memory cells MC and the string selection transistors SST of the cell strings CS1n to CSkn may be commonly connected to the bit line BLn.

Rows of the plurality of cell strings CS may be respectively connected to different common source lines CSL1 to CSLk. For example, the string selection transistors SST of the cell strings CS11 to CS1n may be commonly connected to the common source line CSL1, and the string selection transistors SST of the cell strings CSk1 to CSkn may be commonly connected to the common source line CSLk.

The memory cells MC located at the same height from the substrate 101 or the string selection transistors SST may be commonly connected to one word line WL, and the memory cells MC located at different heights therefrom may be respectively connected to different word lines WL1 to WLn.

The circuit structure shown is an example. For example, the number of rows of the cell strings CS may increase or decrease. As the number of rows of the cell string CS changes, the number of string selection lines connected to the rows of the cell string CS and the number of cell strings CS connected to one bit line BL may also change. As the number of rows of the cell strings CS changes, the number of common source lines connected to the rows of the cell strings CS may also change.

The number of columns of the cell strings CS may also increase or decrease. As the number of columns of the cell string CS changes, the number of bit lines BL connected to the columns of the cell strings CS and the number of cell strings CS connected to one string selection line may also change.

The height of the cell string CS may also increase or decrease. For example, the number of memory cells MC stacked on each cell string CS may increase or decrease. As the number of memory cells MC stacked on each cell string CS changes, the number of word lines WL may also change. For example, the number of string selection transistors provided in each of the cell strings CS may increase. As the number of string selection transistors provided in each of the cell strings CS changes, the number of string selection lines or common source lines may also change. When the number of string selection transistors SST increases, the string selection transistors SST may be stacked in the same form as the memory cells MC.

For example, writing and reading may be performed in units of rows of cell strings CS. The cell strings CS may be selected in units of one row by the common source line CSL, and the cell strings CS may be selected in units of one row by the string selection lines SSL. Also, voltage may be applied to the common source lines CSL in units of at least two common source lines. The voltage may be applied to the common source lines CSL in units of all common source lines.

In the selected row of the cell strings CS, writing and reading may be performed in units of pages. A page may be one row of memory cells MC connected to one word line WL. In the selected row of cell strings CSs, the memory cells MC may be selected in units of pages by the word lines WL. For example, each gate electrode 131 of FIG. 1 may be connected to one of the word line WL and the string selection line SSL.

The memory cell MC has a circuit structure in which a transistor including the gate electrode 131, the separation layer 132, and the channel layer 122 is connected to the charge trap layer 126.

These memory cells MC are continuously arranged in a vertical direction (Z direction) to constitute the cell string CS. Also, as shown in the circuit diagram of FIG. 9, both ends of the cell string CS may be connected to the common source line CSL and the bit line BL. By applying voltage to the common source line CSL and the bit line BL, program, read, and erase processes may be performed on the plurality of memory cells MC.

For example, when the memory cell MC to be programmed is selected, a gate voltage value of a selected cell is adjusted so that no channel is formed in the selected cell, that is, a channel is off, and gate voltage values of unselected cells are adjusted so that the channel is on in the unselected cells. Accordingly, charges are tunneled through the charge tunneling layer 124 by the voltage applied to the common source line CSL and the bit line BL, and are stored in the charge trap layer 126 of the selected memory cell MC, and thus, desired information of 1 or 0 may be programmed in the selected memory cell MC.

In a read operation, similarly, reading may be performed on the selected cell. That is, a cell state (1 or 0) may be confirmed by adjusting the gate voltage applied to each gate electrode 131 so that the selected memory cell MC is in a channel-off state and the unselected memory cells are in a channel-on state, and then, measuring current flowing in the memory cell MC by an applied voltage Vread between the common source line CSL and the bit line BL.

The vertical non-volatile memory device 100 has a structure in which cells are connected in a vertical direction. When information is stored, charges may diffuse in the vertical direction and move to adjacent cells, and thus, the operation of adjacent cells may be affected.

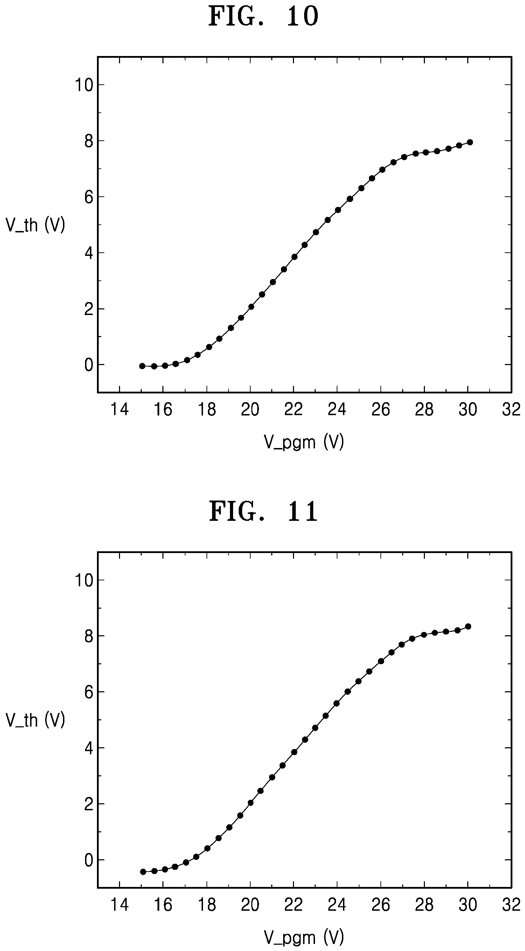

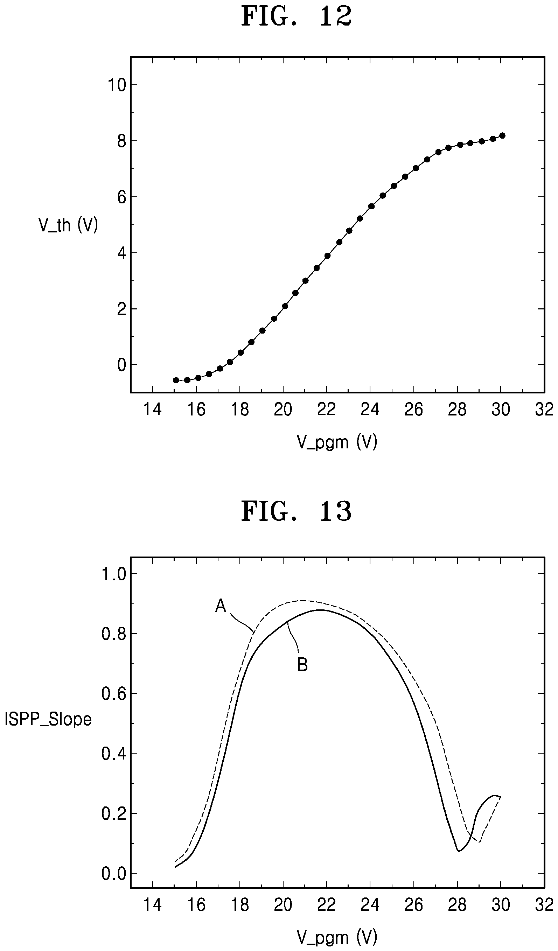

FIG. 10 is a comparative example illustrating a change in a threshold voltage $V\_th$ according to a program voltage $V\_pgm$ when a dielectric layer including ZrO is used as a charge blocking layer. FIGS. 11 and 12 illustrate a change in the threshold voltage $V\_th$ according to the program voltage $V\_pgm$ respectively when an anti-ferroelectric layer is used as the charge blocking layer and when a ferroelectric layer is used as the charge blocking layer. In FIG. 11, the charge blocking layer includes HZO(Hf:Zr=2:8), and, in FIG. 12, the charge blocking layer includes HZO(Hf:Zr=5:5).

FIG. 13 illustrates a change in an incremental step pulse programming (ISPP) slope ISPP_slope according to the program voltage $V\_pgm$ in case A where the anti-ferroelectric layer is used as the charge blocking layer and in case B where the dielectric layer is used as the charge blocking layer. The ISPP slope ISPP_slope is greater in case A where the anti-ferroelectric layer is used as the charge blocking layer than in case B where the dielectric layer is used as the charge blocking layer.

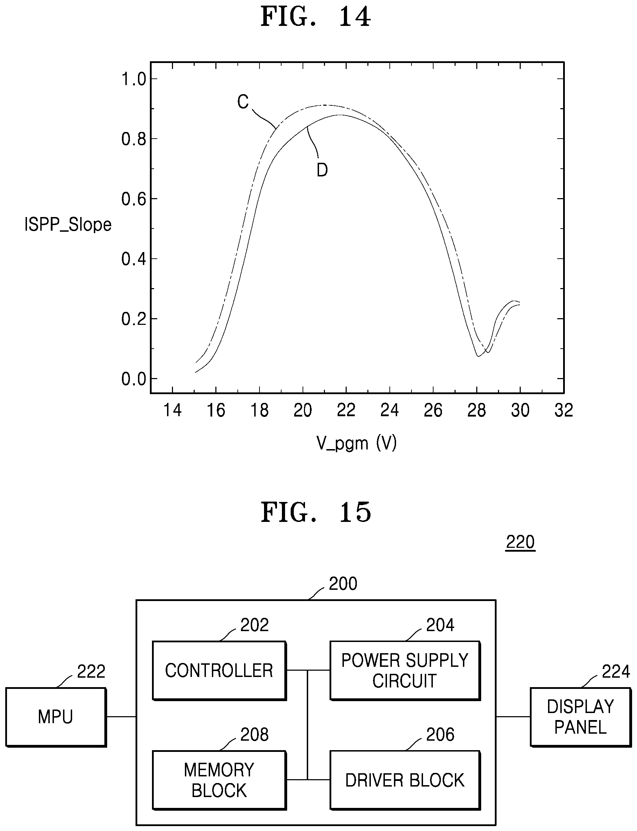

FIG. 14 illustrates a change in the ISPP slope ISPP_slope according to the program voltage $V\_pgm$ in case C where the ferroelectric layer is used as the charge blocking layer and in case D where the dielectric layer is used as the charge blocking layer. The ISPP slope is greater in case C where the ferroelectric layer is used as the charge blocking layer than in case D where the dielectric layer is used as the charge blocking layer. The ISPP slope ISPP_slope is a measure of how much charge is stored in a charge trap layer when a unit voltage is increased above the program voltage $V\_pgm$. In the great ISPP slope ISPP_slope, when an additional voltage higher than a voltage at which data program starts is applied, a large amount of charges may be rapidly stored even with a small additional voltage. Therefore, a large amount of additional voltage may not be required to complete the data program. As a result, the great ISPP slope means that a final voltage to complete the data program is reduced.

In some example embodiments, a second layer may serve as a seed layer of a first layer. The second layer having a relatively low crystallization temperature is first crystallized, and serves as a crystal nucleus and reduces crystallization energy, and thus, the crystallization of the first layer may be improved. In the case of the first layer crystallized on the second layer of the seed layer as described above, ferroelectric/anti-ferroelectric properties may be enhanced, and thus, a permittivity may be increased.

As described above, the charge blocking layer of the vertical non-volatile memory device according to some example embodiments may include a ferroelectric material or an anti-ferroelectric material, and significantly increase the permittivity of the charge blocking layer, thereby reducing the data program/erase voltage, increasing the speed, and increasing a charge storage amount per unit voltage. Reducing the data program/erase voltage and increasing the speed may reduce the height of the unit element of the vertical non-volatile memory element, thereby increasing the number of stack stages. In addition, performance (e.g., performance of the vertical non-volatile memory device) may be improved by increasing the crystallization of a ferroelectric switching layer of the vertical non-volatile memory device, and thermal process cost thereof may be reduced.

The vertical non-volatile memory device according to some example embodiments has the above advantages and may be applied to various electronic apparatus.

FIG. 15 is a schematic block diagram illustrating a display driver IC (DDI) 200 and a display apparatus 220 including the DDI 200 according to some example embodiments Referring to FIG. 15, the DDI 200 may include a controller 202, a power supply circuit 204, a driver block 206, and a memory block 208. The controller 202 may receive and decode a command applied from a main processing unit (MPU) 222 and control each of the blocks of the DDI 200 to implement an operation according to the command. The power supply circuit 204 may generate a driving voltage in response to control by the controller 202. The driver block 206 may drive a display panel 224 by using the driving voltage generated by the power supply circuit 204 in response to the control by the controller 202. The display panel 224 may be, for example, a liquid crystal display panel, an organic light emitting device (OLED) display panel, or a plasma display panel. The memory block 208 may be a block for temporarily storing commands input to the controller 202 or control signals output from the controller 202 or storing necessary data and may include a memory such as a RAM and/or a ROM. For example, the memory block 208 may include the vertical non-volatile memory device 100 according to some example embodiments, including the example embodiments shown in any one or more of FIGS. 1 to 9.

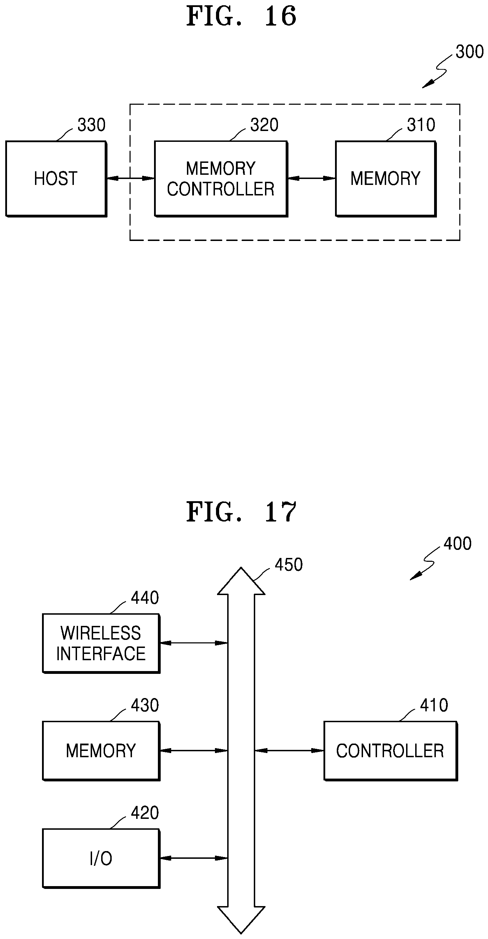

FIG. 16 is a block diagram illustrating an electronic apparatus 300 according to some example embodiments. Referring to FIG. 16, the electronic apparatus 300 may include a memory 310 and a memory controller 320. The memory controller 320 may control the memory 310 to read data from the memory 310 and/or write data into the memory 310 in response to a request from a host 330. The memory 310 may include the vertical non-volatile memory device 100 according to some example embodiments, including the example embodiments shown in any one or more of FIGS. 1 to 9.

FIG. 17 is a block diagram illustrating an electronic apparatus 400 according to some example embodiments. Referring to FIG. 17, the electronic apparatus 400 may configure a wireless communication apparatus or an apparatus capable of transmitting and/or receiving information in a wireless environment. The electronic apparatus 400 may include a controller 410, an input/output (I/O) device 420, a memory 430, and a wireless interface 440, which may be connected to each other through a bus 450.

The controller 410 may include at least one of a microprocessor, a digital signal processor, and any similar processing device. The I/O device 420 may include at least one of a keypad, a keyboard, and a display. The memory 430 may be used to store a command executed by the controller 410. For example, the memory 430 may be used to store user data. The electronic apparatus 400 may use the wireless interface 440 to transmit/receive data through a wireless communication network. The wireless interface 440 may include an antenna and/or a wireless transceiver. In some embodiments, the electronic apparatus 400 may be used in the communication interface protocols of third-generation communication systems such as Code Division Multiple Access (CDMA), Global System for Mobile Communications (GSM), North American Digital Cellular (NADC), Extended Time Division Multiple Access (E-TDMA), and/or Wideband Code Division Multiple Access (WCDMA). The memory 430 of the electronic apparatus 400 may include the memory device according to some example embodiments, including the example embodiments shown in any one or more of FIGS. 1 to 9.

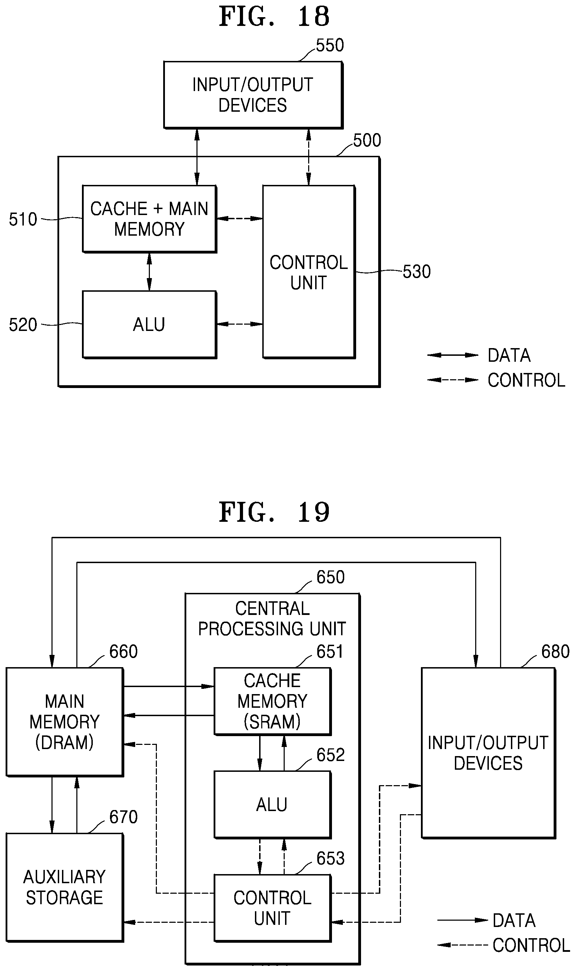

FIGS. 18 and 19 are conceptual diagrams schematically illustrating device architectures applicable to an electronic apparatus according to some example embodiments.

Referring to FIG. 18, an electronic apparatus architecture 500 may include a memory unit 510 and a control unit 530 and may further include an arithmetic logic unit (ALU) 520. The memory unit 510, the ALU 520, and the control unit 530 may be electrically connected to each other. For example, the electronic apparatus architecture 500 may be implemented as a single chip including the memory unit 510, the ALU 520, and the control unit 530. Specifically, the memory unit 510, the ALU 520, and the control unit 530 may be connected to each other through a metal line on-chip to directly communicate with each other. The memory unit 510, the ALU 520, and the control unit 530 may be monolithically integrated on one substrate 101 to constitute one chip. An input/output device 550 may be connected to the electronic apparatus architecture (chip) 500. Also, the memory unit 510 may include both a main memory and a cache memory. This electronic apparatus architecture (chip) 500 may be an on-chip memory processing unit. Each of the memory unit 510, the ALU 520, and/or the control unit 530 may independently include the vertical non-volatile memory device 100 according to some example embodiments, including the example embodiments shown in any one or more of FIGS. 1 to 9.

Referring to FIG. 19, a cache memory 651, an ALU 652, and a control unit 653 may constitute a central processing unit (CPU) 650, and the cache memory 651 may include a static random access memory (SRAM). Separately from the CPU 650, a main memory 660 and an auxiliary storage 670 may be provided and an input/output device 680 may also be provided. The main memory 660 may be, for example, a dynamic random access memory (DRAM) and may include the vertical non-volatile memory device 100 according to some example embodiments, including the example embodiments shown in any one or more of FIGS. 1 to 9.

As described herein, any devices, systems, modules, portions, units, controllers, circuits, and/or portions thereof according to any of the example embodiments, and/or any portions thereof (including, without limitation, display apparatus 220, DDI 200, MPU 222, display panel 224, controller 202, power supply circuit 204, driver block 206, memory block 208, electronic apparatus 300, memory 310, memory controller 320, host 330, electronic apparatus 400, controller 410, input/output (I/O) device 420, memory 430, wireless interface 440, electronic apparatus architecture 500, memory unit 510, control unit 530, ALU 520, input/output devices 550, CPU 650, cache memory 651, ALU 652, control unit 653, main memory 660, auxiliary storage 670, input/output devices 680, any portion thereof, or the like) may include, may be included in, and/or may be implemented by one or more instances of processing circuitry such as hardware including logic circuits; a hardware/software combination such as a processor executing software; or a combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a solid state drive (SSD), storing a program of instructions, and a processor (e.g., CPU) configured to execute the program of instructions to implement the functionality and/or methods performed by some or all of any devices, systems, modules, portions, units, controllers, circuits, and/or portions thereof according to any of the example embodiments.

In some example embodiments, the electronic apparatus architecture may be implemented in a form in which computing unit devices and memory unit devices are adjacent to each other in one chip without distinction between subunits.

The vertical non-volatile memory device according to some example embodiments may be applied to various user devices such as a computer, a portable computer, an ultra mobile PC (UMPC), a workstation, a net-book, a PDA, a portable computer, a web tablet, a wireless phone, a mobile phone, a smart phone, a digital camera, a digital audio recorder, a digital audio player, a digital picture recorder, a digital picture player, a digital video recorder, a digital video player, a device capable of transmitting and receiving information in a wireless environment, and a home network.

A vertical non-volatile memory device according to some example embodiments may include a charge blocking layer including a ferroelectric material or an anti-ferroelectric material, and a seed layer, thereby reducing a data program/erase voltage and improving a charge storage amount per unit voltage. The crystallization of the charge blocking layer including the ferroelectric material or the anti-ferroelectric material may be increased by the seed layer, and ferroelectric properties may be improved, which increases capacitance, thereby reducing the data program/erase voltage. As the data program/erase voltage is reduced, the size of a unit cell of the vertical non-volatile memory device may be reduced, and the number of stack stages may be increased.

It should be understood that example embodiments described herein should be considered in a descriptive sense only and not for purposes of limitation. Descriptions of features or aspects within each example embodiment should typically be considered as available for other similar features or aspects in some example embodiments. While some example embodiments have been described with reference to the figures, it will be understood by those of ordinary skill in the art that various changes in form and details may be made therein without departing from the scope as defined by the following claims.

**Claims**

1.  A vertical non-volatile memory device comprising:

    a plurality of cell strings, each cell string of the plurality of cell strings including

        a channel layer,
        a charge tunneling layer on the channel layer,
        a charge trap layer on the charge tunneling layer,

a first charge blocking layer on the charge trap layer,
a second charge blocking layer on the first charge blocking layer, and
a gate electrode on the second charge blocking layer,

wherein the second charge blocking layer includes a first layer and a second layer, the first layer including a ferroelectric material or an anti-ferroelectric material, the second layer configured to increase crystallization of the first layer.

2. The vertical non-volatile memory device of claim 1, wherein

the second layer is located between the first charge blocking layer and the first layer, or
the second layer is located between the first layer and the gate electrode.

3. The vertical non-volatile memory device of claim 1 or 2, wherein the first layer has a remnant polarization in a range of 10 $\mu C/cm^2$ to 30 $\mu C/cm^2$.

4. The vertical non-volatile memory device of any preceding claim, wherein the first layer has a permittivity in a range of 30 to 40.

5. The vertical non-volatile memory device of any preceding claim, wherein the second layer includes one of ZrO, HfO, TaO, SiO, doped ZrO, doped HfO, doped TaO, doped SiO, Zr(O)N, Hf(O)N, Ta(O)N, Si(O)N, doped Zr(O)N, doped Hf(O)N, doped Ta(O)N, doped Si(O)N, or any combination thereof.

6. The vertical non-volatile memory device of any preceding claim, wherein the second layer has an amorphous crystal phase, a monoclinic crystal phase, a tetragonal crystal phase, an orthorhombic crystal phase, or a cubic crystal phase.

7. The vertical non-volatile memory device of any preceding claim, wherein the first layer includes a fluorite-based material, a perovskite-based material, or a wurtzite-based material, and optionally wherein the fluorite-based material includes $HfO_2$ or $ZrO_2$, and further optionally wherein the fluorite-based material further includes a dopant, and the dopant includes at least one of Al, Ga, Co, Ni, Mg, In, La, Y, Nd, Sm, Er, Sr, Ba, Gd, Ge, N, or Si.

8. The vertical non-volatile memory device of claim 7, wherein the perovskite-based material includes a material having an ABOs composition, wherein A and B are metal elements, and optionally wherein the perovskite-based material includes at least one of PbZrOs, PbTiOs, BaTiOs, SrTiOs, or CaTiOs.

9. The vertical non-volatile memory device of claim 7 or 8, wherein the wurtzite-based material includes at least one of AIN, GaN, InN, doped AIN, doped GaN, or doped InN.

10. The vertical non-volatile memory device of any preceding claim, wherein a crystallization temperature of the first layer is 600 °C to 800 °C, and a crystallization temperature of the second layer is 200 °C to 400 °C.

11. The vertical non-volatile memory device of any preceding claim, wherein the first layer has a thickness in a range of 1 nm to 3 nm.

12. The vertical non-volatile memory device of any preceding claim, wherein the second layer has a thickness in a range of 0.5 nm to 1.5 nm.

13. The vertical non-volatile memory device of any preceding claim, wherein the first layer and the second layer are configured to surround three surfaces of the gate electrode.

14. The vertical non-volatile memory device of any preceding claim, further comprising: a diffusion barrier layer between the gate electrode and the second charge blocking layer, and optionally wherein

the diffusion barrier layer includes at least one of titanium (Ti), zirconium (Zr), vanadium (V), aluminum (AI), lanthanum (La), niobium (Nb), or tantalum (Ta), or
the diffusion barrier layer includes nitride including at least one of titanium (Ti), zirconium (Zr), vanadium (V), aluminum (AI), lanthanum (La), niobium (Nb), or tantalum (Ta).

15. An electronic apparatus, comprising:

a memory; and
a memory controller configured to control the memory to read data from the memory and/or write data to the memory,
wherein the memory comprises a vertical non-volatile memory device according to any preceding claim.

# FIG. 1

# FIG. 2

# FIG. 3

A

132

131

128
129 } CB

129a  129b
129

122 124 126 128

# FIG. 4

A

132

131

128
129 } CB

129b  129a
129

122 124 126 128

# FIG. 5

A

132

131

128
129 } CB

129a 129b
129

122 124 126 128

# FIG. 6

A

132

131

128
129 } CB

129b 129a
129

122 124 126 128

## FIG. 7

A

132

131

128
129 } CB

129b 129a 129c

129

122 124 126 128

## FIG. 8

A

132

131

128
129 } CB

129b 129a

129        135

122 124 126 128

# FIG. 9

# FIG. 10

# FIG. 11

# FIG. 12

# FIG. 13

# FIG. 14

# FIG. 15

# FIG. 16

300

330

HOST

320

MEMORY
CONTROLLER

310

MEMORY

# FIG. 17

400

450

440

WIRELESS
INTERFACE

430

MEMORY

420

I/O

410

CONTROLLER

# FIG. 18

INPUT/OUTPUT DEVICES — 550

500

510 — CACHE + MAIN MEMORY

CONTROL UNIT — 530

520 — ALU

——→ DATA
- - -→ CONTROL

# FIG. 19

650

CENTRAL PROCESSING UNIT

660

651

MAIN MEMORY (DRAM)

CACHE MEMORY (SRAM)

680

INPUT/OUTPUT DEVICES

652

670

ALU

AUXILIARY STORAGE

653

CONTROL UNIT

——→ DATA
- - -→ CONTROL

Europäisches
Patentamt

European
Patent Office

Office européen
des brevets

# EUROPEAN SEARCH REPORT

**Application Number**

EP 24 21 8036

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/304987 A1 (DONG YINGDA [US] ET AL) 3 October 2019 (2019-10-03) | 1,5,15 | INV.<br>H10B51/20 |
| Y | * paragraphs [0022] - [0043], [0060] - [0086]; figures 1G, 4A-4E * | 2-4,6-14 | H10D30/69<br>H10D64/01<br>H10D64/68 |
| Y | US 2019/244973 A1 (YOO HYANGKEUN [KR]) 8 August 2019 (2019-08-08)<br>* paragraphs [0005], [0040] - [0069]; claims 1, 19; figure 3 * | 2,6-9,<br>11,12 | |
| Y | US 11 107 901 B2 (SANDISK TECHNOLOGIES LLC [US]) 31 August 2021 (2021-08-31)<br>* figure 15B * | 13 | |
| Y | CHEN HAIYAN ET AL: "HfO2-based ferroelectrics: From enhancing performance, material design, to applications",<br>APPLIED PHYSICS REVIEWS, AMERICAN INSTITUTE OF PHYSICS, 2 HUNTINGTON QUADRANGLE, MELVILLE, NY 11747,<br>vol. 9, no. 1,<br>2 February 2022 (2022-02-02), XP012263227,<br>DOI: 10.1063/5.0066607<br>[retrieved on 2022-02-02]<br>* the whole document * | 3,4,10 | |
| Y | US 2022/037362 A1 (LIN MENG-HAN [TW] ET AL) 3 February 2022 (2022-02-03)<br>* paragraph [0065] * | 14 | |

**TECHNICAL FIELDS SEARCHED (IPC)**

H10B
H10D

The present search report has been drawn up for all claims

| Place of search | Date of completion of the search | Examiner |
|---|---|---|
| Munich | 2 April 2025 | Alessio Verni, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 8036

This annex lists the patent family members relating to the patent documents cited in the above-mentioned European search report.
The members are as contained in the European Patent Office EDP file on
The European Patent Office is in no way liable for these particulars which are merely given for the purpose of information.

02-04-2025

| Patent document cited in search report | Publication date | Patent family member(s) | | Publication date |
|---|---|---|---|---|
| US 2019304987 A1 | 03-10-2019 | NONE | | |
| US 2019244973 A1 | 08-08-2019 | CN | 110137180 A | 16-08-2019 |
| | | KR | 20190109606 A | 26-09-2019 |
| | | US | 2019244973 A1 | 08-08-2019 |
| US 11107901 B2 | 31-08-2021 | US | 2020321444 A1 | 08-10-2020 |
| | | WO | 2020205021 A1 | 08-10-2020 |
| US 2022037362 A1 | 03-02-2022 | CN | 113675213 A | 19-11-2021 |
| | | DE | 102021100089 A1 | 03-02-2022 |
| | | EP | 3945586 A1 | 02-02-2022 |
| | | JP | 2022027624 A | 10-02-2022 |
| | | KR | 20220015304 A | 08-02-2022 |
| | | TW | 202205623 A | 01-02-2022 |
| | | US | 2022037362 A1 | 03-02-2022 |
| | | US | 2022384347 A1 | 01-12-2022 |
| | | US | 2024164109 A1 | 16-05-2024 |

EPO FORM P0459

For more details about this annex : see Official Journal of the European Patent Office, No. 12/82